# EUROPÄISCHE PATENTSCHRIFT

(11) **EP 3 673 534 B1**
(45) Veröffentlichungstag und Bekanntmachung des Hinweises auf die Patenterteilung: **31.07.2024**
(21) Anmeldenummer: 18758862.9
(22) Anmeldetag: 20.08.2018
(51) Int. Cl.: H01P 5/107, H01P 1/02

(54) **ÜBERGANG VON EINER STREIFENLEITUNG AUF EINEN HOHLLEITER**
TRANSITION FROM A STRIPLINE TO A WAVEGUIDE
TRANSITION ENTRE UNE LIGNE À RUBAN ET UN CONDUCTEUR CREUX

(30) Priorität: 24.08.2017 DE 102017214871
(43) Veröffentlichungstag der Anmeldung: 01.07.2020
(73) Patentinhaber: ASTYX GmbH, 85521 Ottobrunn (DE)
(72) Erfinder: TRUMMER, Stefan, 82041 Oberhaching (DE)
(74) Vertreter: Berkenbrink, Kai-Oliver
(86) Internationale Anmeldenummer: PCT/EP2018/072450
(87) Internationale Veröffentlichungsnummer: WO 2019/038236

(56) Entgegenhaltungen:
- DE-A1- 102015 225 496
- DE-B3- 10 243 671
- DE-C1- 19 725 492
- JP-A- H05 273 234
- US-A1- 2002 163 397
- THOMAS J MULLER ET AL: "Surface-mountable metalized plastic waveguide filter suitable for high volume production", EUROPEAN MICROWAVE CONFERENCE, 2003. 33RD, IEEE, PISCATAWAY, NJ, USA, 1 October 2003 (2003-10-01), pages 1255 - 1258, XP031069954

## Beschreibung

Die vorliegende Erfindung betrifft einen Übergang von einer Streifenleitung auf einen Hohlleiter. Der Übergang erfolgt dadurch, dass sich die Streifenleitung auf einem Substrat befindet, wobei eine Oberseite des Substrates eine metallisierte Fläche und die Unterseite des Substrates eine Metallschicht aufweist, wobei die Oberseite und die Unterseite mit Durchkontaktierungen verbunden sind, wobei die metallisierte Fläche auf der Oberseite des Substrates zumindest teilweise als eine Hohlleiterwand fungiert.

Aufgrund gesteigerter Anforderungen an die Sensorik wie zum Beispiel im Radarbereich gegeben durch die Zielsetzung des autonomen Fahrens, ergeben sich neue Herausforderungen in der Sensorentwicklung. Diese gesteigerten Ansprüche müssen dabei vor allem bei den Antennen der Sensoren berücksichtigt werden, da diese einen entscheidenden Einfluss auf das Gesamtsystem haben. Die derzeit häufig verwendeten planaren Antennen, die sich auf Leiterplatten befinden, können dabei oft nicht mehr die notwendige Leistung erbringen. Deshalb werden vermehrt Hohlleiterantennen eingesetzt. Da sich andere Sensorkomponenten, wie zum Beispiel Empfänger-und Sendechips, weiterhin auf Leiterplatten befinden, sind geeignete Übergänge zwischen Wellenführungen auf Leiterplatten und Wellenführungen in einem Hohlleiter entscheidende Komponenten vieler neuer Sensorsysteme.

Ein Übergang wird beschrieben in: THOMAS J MULLER ET AL: "Surface-mountable metalized plastic waveguide filter suitable for high volume production", EUROPEAN MICROWAVE CONFERENCE 2003. 33RD, 1EEE, PISCATAWAY, NJ, USA, 1. Oktober 2003 (2003-10-01), S. 1255-1258.

Weitere Übergänge von einer Streifenleitung auf einen Hohlleiter werden beispielsweise in US 2002/163397 A1, JP H05 273234 A, DE 197 25 492 C1, DE 10 2015 225496 A1 sowie DE 102 43 671 B3 beschrieben.

Die Druckschrift DE 196 36 890 C1 beschreibt ein Verfahren, das eine Kontaktierung einer Streifenleitung mit einem im Hohlleiter befindlichen Steg beinhaltet. Die Kontaktierung der Hohlleiterwände erfolgt dabei sowohl oberhalb als auch unterhalb des Substrates. Dieses Prinzip hat jedoch den gravierenden Nachteil, dass sich solche Übergänge nur am Rand eines Substrates befinden können.

Aufgrund der gesteigerten Anforderungen an die Sensorsysteme ist es zukünftig notwendig Übergänge auf dem Substrat zu verteilen.

Es ist deshalb eine Aufgabe der vorliegenden Erfindung, einen Übergang von einer Streifenleitung auf einen Hohlleiter bereitzustellen, welcher die im Stand der Technik vorhandenen Nachteile beseitigt oder vermindert und eine notwendige Leitungsführung realisiert.

Die genannte Aufgabe wird gemäß den Merkmalen des unabhängigen Patentanspruchs 1 gelöst.

Ein Vorteil ist dabei, dass die Übergänge flexibel an beliebigen Stellen auf einem Substrat realisiert werden können, so dass notwendige Leitungsführungen erreicht werden. Ein weiterer Vorteil ist, dass ein optimierter Aufbau und eine verbesserte Leistung realisiert werden.

Bevorzugte oder vorteilhafte Ausführungsformen der Erfindung ergeben sich aus den Unteransprüchen, der nachfolgenden Beschreibung sowie den beigefügten Figuren.

Bevorzugt wird die Streifenleitung von einer mit dem Hohlleiter verbundenen stufenartigen Struktur in der Nähe der metallisierten Fläche auf der Oberseite des Substrates kontaktiert.

Die Struktur befindet sich innerhalb eines aus Metall bestehenden oder metallisierten Blockes, und der Block weist mehrere Hohlleiterstrukturen auf, wobei zumindest mehrere Durchkontaktierungen, vorzugsweise direkt, den Block in einem Übergangsbereich kontaktieren.

Der Block weist einen Rechteckhohlleiter auf, in der sich eine elektrische Welle ausbreitet, wobei die Hohlleiterwelle innerhalb des Blockes mittels eines 90°-Knickes weitergeführt wird, so dass die metallisierte Fläche auf der Oberseite des Substrates lediglich in dem Übergangsbereich als Hohlleiterwand fungiert.

Der 90°-Knick befindet sich bevorzugt senkrecht zum Substrat.

Bevorzugt weist der Block mehrere Schichten auf, welche mittels Frästechnik und/oder 3D Drucktechnik und/oder Kunststoff-Spritzgussverfahren hergestellt werden. Ferner kann ein Übergang mittels eines Präge- oder Druckguss- oder Kaltfliessprozess mit anschließender Metallisierung hergestellt werden.

Bevorzugt endet die Streifenleitung an der Stelle, an der sie durch die mit dem Hohlleiter verbundene Struktur kontaktiert wird.

Der Block besteht üblicherweise aus Metall oder aus einem anderen Material, das metallisiert ist, und in verschiedenen miteinander verbundenen Schichten hergestellt werden kann. Die notwendigen Designkriterien wie das Hinzufügen von Radien und Formschrägen oder etwaige Designkriterien können bei dem Block problemlos vorgesehen werden. Des Weiteren kann die stufenartige Kontaktstruktur auch in Form einer oder mehrerer Schrägen ausgeführt werden.

Weitere Merkmale, Vorteile und Wirkungen der Erfindung ergeben sich aus der nachfolgenden Beschreibung von Ausführungsbeispielen sowie der beigefügten Figuren. Dabei zeigen:
**Fig.** 1 einen prinzipiellen Aufbau eines Übergangs;
**Fig.** 2 Komponenten eines Übergangs, die sich direkt an einem Substrat befinden;
**Fig.** 3 Komponenten eines Übergangs, die sich innerhalb eines Blockes befinden;
**Fig.** 4 eine beispielshafte Weiterführung der Hohlleiterwelle in einem Block; und
**Fig.** 5 eine kompakte Ausführung eines Übergangs, wobei ausschließlich ein Block mit einer Hohlleiterstruktur und eine Massefläche auf einem Substrat dargestellt sind.

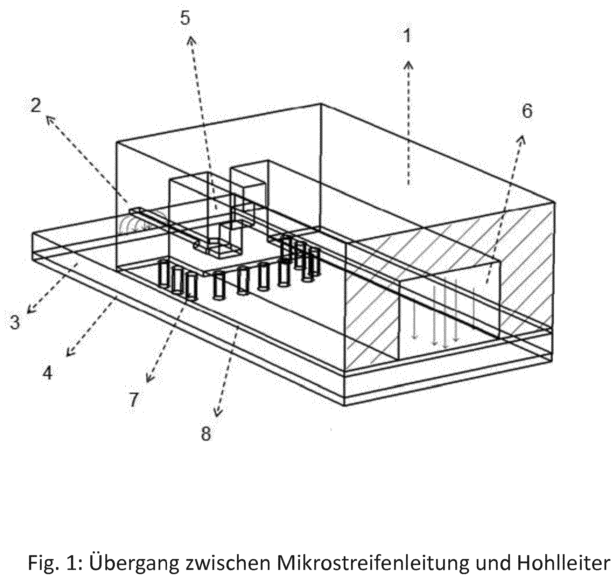

**Fig.** 1 zeigt einen prinzipiellen Aufbau eines Übergangs, welcher aus einer Mikrostreifenleitung besteht. Die Mikrostreifenleitung **2** befindet sich auf einem Substrat **3.** Unterhalb des Substrates befindet sich eine Schicht **4** mit Hochfrequenz-Massepotential. Somit bildet sich der bekannte Grundmode der Mikrostreifenleitung **2,** ein sogenannter Quasi-Transversalelektromagnetischer (Quasi-TEM) Mode, aus. Anschließend wird die Mikrostreifenleitung **2** von einer stufenartigen Struktur **5** kontaktiert. Der Mikrostreifenleitungsmode wird somit in einem H10-Rechteckhohlleitermode **6** transformiert. Die stufenartige Kontaktstruktur **5** befindet sich innerhalb eines Blockes **1,** der alle Hohlleiterstrukturen beinhaltet. Die Kontaktstruktur **5** ist mit einer Hohleiterwand verbunden. Somit besteht der Übergang gemäß **Fig. 1** aus:
- einem Block **1** mit Hohlleiterstrukturen,
- einer Rechteckhohlleiter **6** mit H10-Welle,
- einer metallisierten Fläche **8** auf dem Substrat,
- Durchkontaktierungen (Vias) **7,**
- einer Schicht **4** mit Massepotential,
- einem Substrat **3,**
- einer Mikrostreifenleitung **2** mit Welle im Grundmode, und
- einer stufenartige Struktur **5,** die die Mikrostreifenleitung kontaktiert.

Das für den Mikrostreifenleitungsmode benötigte Hochfrequenz-Massepotential wird von einer Metallschicht auf der Unterseite des Substrates auf die metallisierte Fläche auf der Oberseite des Substrates übergeben, indem beide Flächen mit Durchkontaktierungen im Bereich der stufenartigen Kontaktstruktur verbunden sind. Die metallisierte Fläche auf dem Substrat fungiert dabei teilweise als Wand des Hohlleiters. Die anderen Hohlleiterwände befinden sich in dem Block. Deren Hochfrequenz-Massepotential erhalten sie dadurch, dass einige Durchkontaktierungen, die das Massepotential übergeben, direkt den Block im Übergangsbereich kontaktieren. Aufgrund dieses Aufbaus wird gewährleistet, dass flexibel an beliebigen Stellen auf dem Substrat Übergänge realisiert werden können.

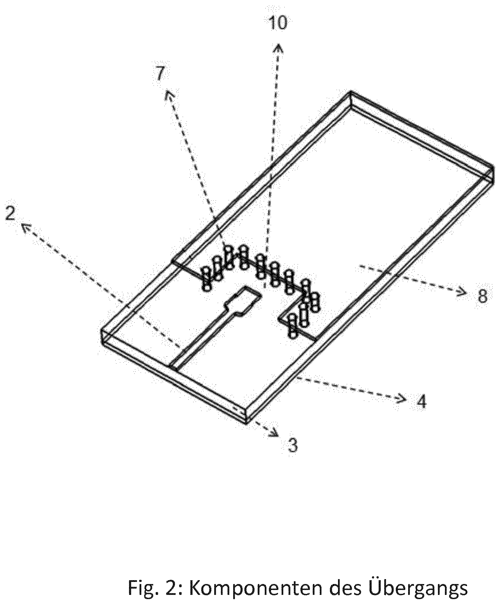

**Fig.** 2 zeigt die Komponenten eines Übergangs, die sich direkt an dem Substrat **3** befinden. Diese sind die Mikrostreifenleitung **2,** eine metallisierte Fläche **8** auf dem Substrat und eine Schicht **4** mit Massepotential unterhalb des Substrates **3.** Dabei weist die Mikrostreifenleitung **2** an deren Ende eine Verbreiterung auf. Die metallisierte Fläche **8** auf dem Substrat beginnt kurz vor dem Ende der Mikrostreifenleitung, wobei sich zwischen der metallisierten Fläche und dem Ende der Mikrostreifenleitung, eine Fläche befindet, die keine Metallisierung aufweist. Dieser Bereich wird als Aussparung **10** der metallisierten Fläche bezeichnet. Entlang dieser Aussparung **10** ist die metallisierte Fläche **8** auf dem Substrat **3** mit einer Schicht **4** mit Massepotential, das sich unterhalb des Substrates **3** befindet, mittels Durchkontaktierungen (Vias) **7** verbunden.

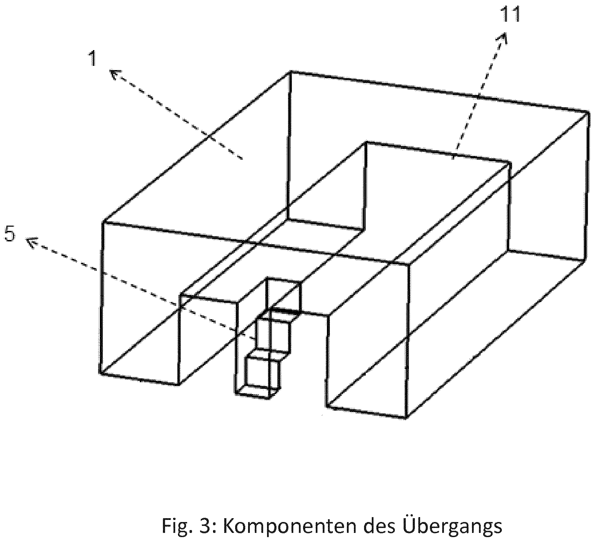

**Fig.** 3 zeigt einen Block **1** mit Hohlleiterstruktur, der sich oberhalb des Substrates befindet. Dieser weist eine rechteckförmige, nach unten offene Aussparung **11** auf, in dessen Quermitte sich am Beginn der Aussparung die stufenartige Kontaktstruktur **5** befindet. Diese besteht aus vorzugsweise drei Stufen, wobei die Struktur zu einer oberen Hohlleiterwand des Rechteckhohlleiters in Längsrichtung des Hohlleiters an Länge zunimmt. Die unterste der drei Stufen kontaktiert dabei die Mikrostreifenleitung **2.** Des Weiteren sind Bereiche des Blockes gekennzeichnet, die die Durchkontaktierungen auf der metallisierten Fläche auf dem Substrat kontaktieren. Die stufenartige Kontaktstruktur besteht aus vorzugsweise drei Stufen, wobei sie jedoch auch aus einer beliebigen Anzahl von Stufen bestehen kann.

Im hinteren Bereich des Blockes beziehungsweise auf der abgewandten Seite der Kontaktstruktur erhält man in der rechteckförmigen Aussparung **11** einen Rechteckhohlleiter, in der sich eine transversal elektrische Welle, eine TE10-Welle, ausbreitet. Der Rechteckhohlleiter ist von drei Seiten durch die Aussparung und von unten durch die metallisierte Fläche auf dem Substrat begrenzt. Da der Übergang nur einen geringen Platz auf dem Substrat einnehmen soll, ist es notwendig die Hohlleiterwelle komplett innerhalb des Blockes weiterzuführen.

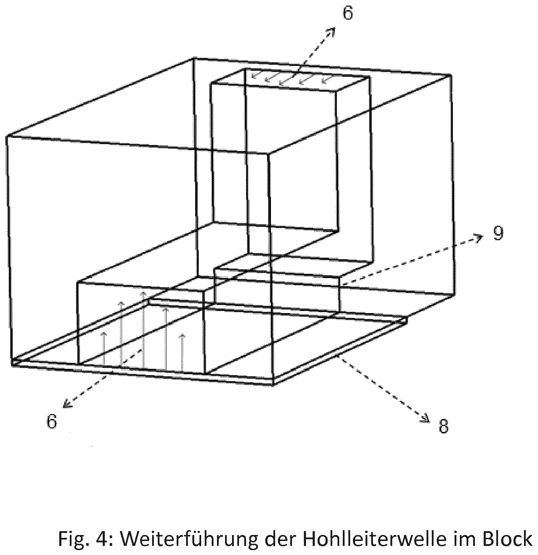

**Fig.** 4 zeigt eine beispielshafte Weiterführung der Hohlleiterwelle in einem Block. Mittels eines 90°-Knickes des Hohlleiters, der eine Stufe **9** aufweist, kann die Welle ausschließlich in einem Block geführt werden. Auf der abgewandten Seite der Stufe in dem Hohlleiter ist auf dem Substrat keine metallisierte Fläche mehr notwendig. Vor der Stufe in dem Hohlleiter besteht jedoch eine metallisierte Fläche **8** auf dem Substrat. Somit stellt **Fig.** 4 die Weiterführung der Hohlleiterwelle in dem Block mittels Rechteckhohlleiter **6** mit H10-Welle im vorderen und hinterem Bereich des Blockes dar, wobei der vordere Bereich des Blockes eine metallisierte Fläche **8** auf dem Substrat aufweist, und eine Stufe im Hohlleiter **9** zum hinteren Bereich führt.

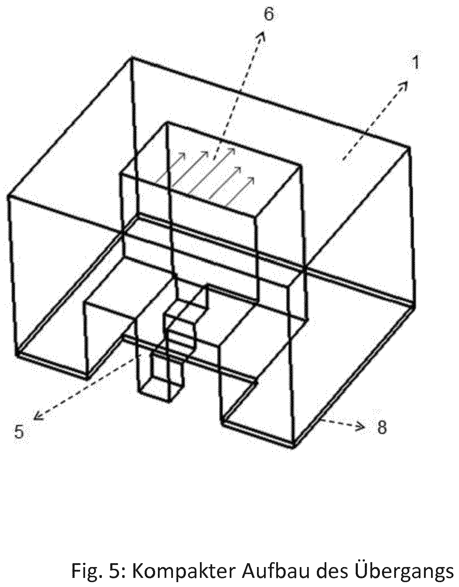

**Fig.** 5 zeigt eine sehr kompakte Ausführung eines Übergangs, wobei ein Block **1** mit einer Hohlleiterstruktur, eine metallisierte Fläche 8 auf dem Substrat **3,** eine stufenartige Kontaktstruktur, und ein Rechteckhohlleiter mit H10-Welle dargestellt sind. Die anderen Komponenten des Übergangs, wie die Mikrostreifenleitung **2,** die Durchkontaktierungen 7, das Substrat **3** und das Massepotential **4** unterhalb des Substrates bleiben dabei in ihrer Anordnung entsprechend **Fig.** 1 erhalten. Die kompakte Variante zeichnet sich dadurch aus, dass sich der 90°-Knick im hinteren Bereich des Blockes beziehungsweise direkt auf der abgewandten Seite der stufenartigen Kontaktstruktur **5** befindet. Die in **Fig.** 4 gezeigte Stufe in dem Hohlleiter 9 ist bei dem kompakten Aufbau gemäß **Fig.** 5 nicht zwangsläufig wesentlich.

### Bezugszeichenliste

- **1**: Block mit Hohlleiterstrukturen
- **2**: Mikrostreifenleitung mit Welle im Grundmode
- **3**: Substrat
- **4**: Schicht mit Massepotential
- **5**: Stufenartige Kontaktstruktur
- **6**: Rechteckhohlleiter mit H10-Welle
- **7**: Durchkontaktierungen (Vias)
- **8**: Metallisierte Fläche auf dem Substrat
- **9**: Stufe im Hohlleiter
- **10**: Aussparung der metallisierten Fläche
- **11**: Rechteckförmige Aussparung

## Patentansprüche

1. Übergang von einer Streifenleitung auf einen Hohlleiter, wobei sich die Streifenleitung, bevorzugt eine Mikrostreifenleitung (2), auf einem Substrat (3) befindet, wobei eine Oberseite des Substrates eine metallisierte Fläche (8) und die Unterseite des Substrates eine Metallschicht, bevorzugt eine Hochfrequenz-Massepotential-Schicht (4), aufweist, wobei die Oberseite und die Unterseite mit Durchkontaktierungen (7) verbunden sind,
wobei die metallisierte Fläche auf der Oberseite des Substrates zumindest teilweise als eine Hohlleiterwand fungiert,
wobei die Streifenleitung von einer mit dem Hohlleiter verbundenen stufenartigen Struktur (5) kontaktiert wird, die sich innerhalb eines aus Metall bestehenden oder metallisierten Blockes (l) befindet, wobei der Block mehrere Hohlleiterstrukturen aufweist, und wobei in einem Übergangsbereich mehrere Durchkontaktierungen den Block kontaktieren,
wobei
der Block einen Rechteckhohlleiter (6) aufweist, der eine elektrische Welle ausbreitet, wobei die Hohlleiterwelle innerhalb des Blocks mittels eines 90 ⁰ -Knickes weitergeführt wird, der sich direkt auf der abgewandten Seite der stufenartigen Struktur (5) befindet, so dass die metallisierte Fläche auf der Oberseite des Substrats lediglich in dem Übergangsbereich als Hohlleiterwand fungiert.

2. Übergang nach Anspruch l, wobei die Streifenleitung in der Nähe der metallisierten Fläche auf der Oberseite des Substrats von der stufenartigen Struktur kontaktiert wird.

3. Übergang nach Anspruch 1 und 2, wobei im Übergangsbereich mehrere Durchkontaktierungen den Block direkt kontaktieren.

4. Übergang nach Anspruch l, wobei sich der 90 ⁰ -Knick senkrecht zum Substrat befindet

5. Übergang nach einem der vorgehenden Ansprüche, wobei der Block mehrere Schichten aufweist, welche mittels Frästechnik und/oder 3D Drucktechnik und/oder Kunststoff-Spitzgussverfahren hergestellt werden

## Claims

1. Transition from a stripline to a waveguide, wherein the stripline, preferably a microstrip line (2), is located on a substrate (3), wherein an upper side of the substrate has a metallised surface (8) and the lower side of the substrate has a metal layer, preferably a high-frequency ground-potential layer (4), wherein the upper side and the lower side are connected by vias (7),
wherein the metallised surface on the upper side of the substrate at least partially acts as a waveguide wall,
wherein the stripline is contacted by a step-like structure (5) connected to the waveguide, which is located within a block (1) that is metallised or consists of metal, wherein the block comprises a plurality of waveguide structures, and wherein a plurality of vias contact the block in a transition region,
wherein the block has a rectangular waveguide (6) which propagates an electrical wave, wherein the waveguide wave is guided onward within the block by means of a 90° bend which is located directly on the remote side of the step-like structure (5), so that the metallised surface on the upper side of the substrate acts as a waveguide wall only in the transition region.

2. Transition according to claim 1, wherein
the stripline is contacted by the step-like structure in the vicinity of the metallised surface.

3. Transition according to claim 1 and 2, wherein
a plurality of vias contact the block directly in the transition region.

4. Transition according to claim 1, wherein
the 90°-bend is located perpendicular to the substrate.

5. Transition according to any one of the preceding claims, wherein
the block has a plurality of layers which are produced by means of milling technology and/or 3D printing technology and/or plastic injection moulding processes.

## Revendications

1. Transition entre une ligne à ruban et un conducteur creux, sachant que la ligne à ruban, de préférence une ligne à microruban (2), se trouve sur un substrat (3), sachant qu'une face supérieure du substrat comporte une surface métallisée (8) et la face inférieure du substrat une couche de métal, de préférence une couche à potentiel de masse à haute fréquence (4), sachant que la face supérieure et la face inférieure sont reliées à des métallisations de trous (7),
sachant que la surface métallisée sur la face supérieure du substrat fonctionne au moins en partie comme une paroi de conducteur creux,
sachant que la ligne à ruban est mise en contact par une structure (5) échelonnée reliée au conducteur creux, qui se trouve à l'intérieur d'un bloc (1) composé de métal ou métallisé, sachant que le bloc comporte plusieurs structures de conducteur creux et sachant que dans une zone de transition plusieurs métallisations de trous sont en contact avec le bloc,
sachant que le bloc comporte un conducteur creux rectangulaire (6), qui propage une onde électrique, sachant que l'onde du conducteur creux est poursuivie à l'intérieur du bloc au moyen d'une courbe à 90°, qui se trouve directement sur le côté opposé de la structure échelonnée (5) de telle manière que la surface métallisée sur la face supérieure du substrat ne fonctionne dans la zone de transition que comme paroi de conducteur creux.

2. Transition selon la revendication 1, sachant que la ligne à ruban à proximité de la surface métallisée est mise en contact sur la face supérieure du substrat depuis la structure échelonnée.

3. Transition selon les revendications 1 et 2, sachant que dans
la zone de transition plusieurs métallisations des trous sont directement en contact avec le bloc.

4. Transition selon la revendication 1, sachant que la courbe à 90° se trouve perpendiculaire au substrat.

5. Transition selon l'une quelconque des revendications précédentes, sachant que
le bloc comporte plusieurs couches, lesquelles sont fabriquées au moyen de la technique de fraisage et/ou de la technique d'impression en 3D et/ou par un procédé de moulage par injection de matière plastique.
